# EUROPEAN PATENT SPECIFICATION

(11) **EP 3 446 075 B1**
(45) Date of publication and mention of the grant of the patent: **01.04.2020**
(21) Application number: 16717937.3
(22) Date of filing: 21.04.2016
(51) Int. Cl.: G01F 15/00, G01D 4/00, G01R 11/25, G01R 22/06

(54) **DEVICE FOR DETECTING FRAUD IN METERS AND RELATED METHOD**
VORRICHTUNG ZUR AUFDECKUNG VON BETRUG BEI MESSGERÄTEN UND ENTSPRECHENDES VERFAHREN
DISPOSITIF POUR DÉTECTER UNE FRAUDE DANS DES COMPTEURS ET PROCÉDÉ ASSOCIÉ

(43) Date of publication of application: 27.02.2019
(73) Proprietor: Consejo Superior de Investigaciones Científicas (CSIC), 28006 Madrid (ES); Universitat Autónoma De Barcelona (UAB), 08193 Bellaterra (Barcelona) (ES); Kromschroeder, S.A., 08902 L'hospitalet De Llobregat (ES)
(72) Inventor: FORTUNA PÉREZ, Hilario, 08902 L'Hospitalet (Barcelona) (ES); VALERO URREA, José, 08902 L'Hospitalet (Barcelona) (ES); GRANADOS GARCÍA, Javier Alberto José, 08193 Bellaterra (Cerdanyola del Valles) (ES); RICART MIRÓ, Susana, 08193 Bellaterra (Cerdanyola del Valles) (ES); PALMER PARICIO, Javier, 08193 Bellaterra (Cerdanyola del Valles) (ES); ALCALDE ARAGONÉS, Ana, 08193 Bellaterra (Cerdanyola del Valles) (ES); CARRABINA BORDOLL, Jordi, 08193 Bellaterra (Cerdanyola del Valles) (ES); CASTELLS RUFAS, David, 08193 Bellaterra (Cerdanyola del Valles) (ES)
(74) Representative: Pons Ariño, Angel
(86) International application number: PCT/EP2016/058934
(87) International publication number: WO 2017/182087

(56) References cited:
- WO-A2-03/065055
- GB-A- 2 178 481
- US-A1- 2008 210 757

## Description

### OBJECT OF THE INVENTION

The present invention relates to a device for detecting fraud in meters, the kind of fraud that takes place by the use of an external magnet attached over the meter's gauge. This invention relates to gauge meters which possess mobile parts whose motion can be stopped by the application of a magnetic field. The invention is especially relevant for fluid or energy meters, but it is not restricted to these kinds of meters. The invention can generally be applied to any meter possessing mobile parts whose motion can be stopped by the application of a magnetic field.

A first object of the invention is a device for detecting fraud in meters (i.e. fluid or energy meters) in the form of a magnetic strip with an encoded pattern.

A second object of the invention is a method for detecting fraud in meters that allows meter readers check possible manipulation over the meter.

### BACKGROUND OF THE INVENTION

A frequent fraud that fluid or energy meter readers find when checking a fluid or energy meter, particularly gas, water and electricity meters, is that the measure can be disrupted due to the application of a strong magnet, with a magnetic flux density sufficient to stop the motion of mobile parts and consequently stopping the metering function of the meter, freezing the current value measured even if water, gas or energy is being consumed. For the sake of information and not the sake of limitation of the invention, it is known that a magnetic flux density higher than approximately 0.2 Tesla, when applied over the gauge is sufficient to stop meters available in the market and installed in residences. This kind of manipulation doesn't leave any mark and the human meter readers don't have an accurate idea of the time it has been manipulated or if it has been really manipulated, so they can only rely in estimations of the gas consumption.

Most of the solutions found to avoid that problem are based in mechanical approaches. Some documents related to this kind of detection are US6666083B2 and EP1564533B1.

US6098456 discloses an anti-fraud liquid meters having a drive and driven magnets with double polarity faces, that establishes a magnetic equilibrium with an external magnet which blocks the meter. This is a viable solution for new installations, which are no longer vulnerable to the effect of external magnets, but there's still a big settled base of old models, which turns too expensive to do a total substitution for new ones, or even an intrusive modification of the actual meters. These systems use magnets inside the meter to overcome the effect of a magnetic intrusion.

EP1921426A1 discloses a tamper-proof counter for a flow meter that has a counting device operated by a measuring device, which is displaceable by a flow medium e.g. gas, in flow. A sensor e.g. reflection photo sensor, is provided for detecting external force impact on the counting device, where deflection of a protective housing is automatically detectable by the sensor. However, this counting device is efficient only if an impact has been directed to the counting device.

WO03065055A2 discloses a device for detecting fraud in meters according to the preamble of claim 1.

The device and method for detecting fraud in fluid or energy or general application meters of the present invention solve the above cited drawbacks providing a non-intrusive device and method to check possible fraud in meters and any other devices that can be manipulated with the use of external magnets.

### DESCRIPTION OF THE INVENTION

The present invention relates to a device for detecting fraud in meters that provides a cheap and non-intrusive qualitative tool to detect this fraud that takes place by enclosing a strong magnet on a gauge of the meter, causing a stop in the mobile parts of the measurement device and consequently a stop in the count of the service or goods being provided. Goods being provided may include fluids like water and gas measured by meters. Services being provided may include electricity measured by energy meters. This invention relates to gauge meters which possess mobile parts whose motion can be stopped by the application of a magnetic field. The invention is especially relevant for fluid or energy meters, but it is not restricted to these kinds of meters. The invention can generally be applied to any meter possessing mobile parts whose motion can be stopped by the application of a magnetic field, so that then measurement is stopped.

The device for detecting fraud in meters comprises at least one magnetic strip and means to couple the at least one magnetic strip to the meter. The magnetic strip can have any format, including circular, triangular, rectangular elliptical and other possible formats. The means to couple the magnetic strip to the meter include gluing, screwing, riveting or other forms of coupling or attaching the magnetic strip. The means to couple the at least one magnetic strip to the meter could also comprise a label coupled to the meter in such a way that the magnetic strip is applied on a label that is then attached to the body or the gauge of the meter. This label can be done in any format or shape and the label has the function to act as part of the means to couple the magnetic strip to the meter. The working principle of the invention is that the magnetic strip has its intrinsic pattern altered by the application of a magnetic field. As the fraud is perpetrated by applying magnetic fields using magnets, this is detected as a visible modification with respect to the original pattern in the magnetic field.

The at least one magnetic strip is coded with a magnetic pattern, wherein the magnetic pattern of the at least one magnetic strip is destroyable by the application of an external magnetic field on the label.

Optionally, the device also comprises a magnetic viewing film being capable of reacting to the external magnetic field applied on the label and being capable of displaying the magnetic pattern of the at least one magnetic strip. This magnetic viewing film provides a device for detecting fraud in meters that discerns if the magnetic pattern coded in the at least one magnetic strip has been destroyed by the use of an external magnetic field applied on the label.

The size of the label of the device can be optimized for each type of meter that can be affected by an external magnetic field.

The less the distance of the label to the gauge is, the same magnetic field is applied on the label than the magnetic field applied on the gauge.

The present invention also relates to a method for detecting fraud in meters comprising the following stages:
- a stage of attaching at least one magnetic strip coded with a magnetic pattern to the meter,
- a stage of inspecting the magnetic strip to verify if the magnetic pattern has been changed.

Optionally, the stage of attaching the at least one magnetic strip coded with the a magnetic pattern to the meter comprises attaching the at least one magnetic strip to a label before attaching of the label and the at least one magnetic strip to the meter.

Optionally, the method also comprises a stage of coding the at least one magnetic strip with the magnetic pattern previous to the stage of attaching the at least one magnetic strip coded with the magnetic pattern to the label or to the meter.

Optionally, the method also comprises a stage of checking a magnetic viewing film, wherein the magnetic viewing film is capable of reacting to the external magnetic field applied on the at least one magnetic strip and being capable of displaying the magnetic pattern of the at least one magnetic strip, thus discerning if the magnetic pattern coded in the at least one magnetic strip has been at least partially damaged or destroyed by the use of the external magnetic field applied on the at least one magnetic strip.

The result of the method of detecting fraud is positive, indicating that fraud was attempted, if the magnetic pattern has changed. If the magnetic pattern remains unchanged, the result of the method to detect fraud is negative, indicating that no magnetic field was applied to perform fraud.

### BRIEF DESCRIPTION OF THE DRAWINGS

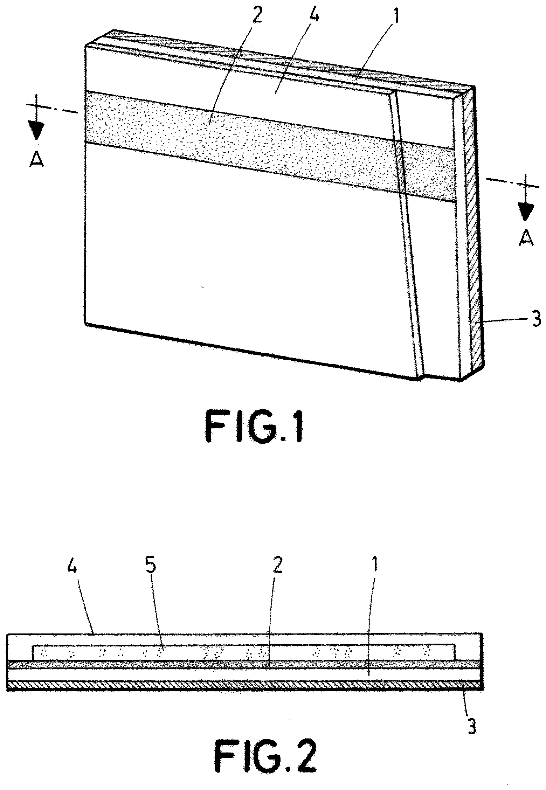

Figure 1 shows a perspective view of the device for detecting fraud in meters of the present invention according to the third preferred embodiment.
Figure 2 shows a section view AA of the Figure 1.
Figure 3 shows a perspective view of a meter, emphasizing the position of the device shown in Figure1 or Figure 2.
Figures 4 and 5 show two different schematic views of a stage of checking a magnetic viewing film of the method for detecting fraud in meters of the present invention, using an external magnetic viewing film tool.

### PREFERRED EMBODIMENT OF THE INVENTION

In a preferred embodiment of the invention, the device for detecting fraud in meters comprises a label (1) preferably comprised of substrate paper being coupled to a gauge (7) which does the count of the consumption of the meter (6).

The device further comprises a magnetic strip (2) previously coded with a magnetic pattern, wherein the magnetic strip (2) is preferably stuck to or compressed over the label (1) and wherein the magnetic pattern of the magnetic strip (2) is destroyable by the application of an external magnetic field on the label (1).

The magnetic strip (2) presents a moderate to high coercivity according to the current magnetic band standards, i.e. higher than around 2700 Oersted, to ensure the stability of the coded magnetic pattern and according to the magnetic sensitivity of the gauge (7). At the same time the magnetic strip (2) is weak enough to be destroyed with the proximity of an external magnetic field, used to perpetrate the fraud. It is known that usually a magnetic flux density higher than approximately 0.2T that blocks the metering operation by disrupting the proper measure of the gauge (7), this value is provided as an information of the current practice used to commit frauds, and not as a limitation of the invention.

The device further comprises fixing means (3) for permanently joining the label (1), and in consequence the magnetic strip (2), to the meter (3). Preferably, the fixing means (2) are a glued film. This glued film is heavily attached to the meter (6), so not even corners are easily detached. In case the label (1) is scratched, the glued film leaves some rests in the surface of the meter (6) to advise the inspectors or human readers that an aggressive action has took place.

The device further comprises a protective layer (4) disposed over the label (1) which covers entirely the device and protects it from atmospheric conditions (humidity, UV radiation, etc).

The device further comprises a magnetic viewing film (5) being capable of reacting to the external magnetic field applied on the label (1) and being capable of displaying the magnetic pattern of the magnetic strip (2) for discerning if the magnetic pattern coded in the magnetic strip (2) has been destroyed by the use of an external magnetic field applied on the label (1).

Preferably, the magnetic viewing film (5) comprises particles contained inside it suspended in a fluid carrier, which allows said particles to respond to the external magnetic field and be orientated over it, so the magnetic pattern is visually displayed. Most preferably, the magnetic viewing film (5) is encapsulated between two transparent layers (not shown).

In a first preferred embodiment, the magnetic viewing film (5) is a microencapsulated flexible viewing film comprising two thin transparent layers with magnetic micro-particles (mainly nickel or a nickel alloy) captured in between. The particles have enough space to move and reposition when a magnetic field is applied. These films can be easily manipulated. The magnetic viewing film (5) so constituted comprises a transparent capsule (not shown) to protect it (5).

In a second preferred embodiment, the magnetic viewing film (5) is a magnetorheological fluid (MRF). The production of this MRF consists essentially in a dispersion of magnetic micro-particles (preferably of iron, nickel or cobalt, and their alloys with a size smaller than 10 µm) on a fluid carrier (preferably a silicone oil or a mineral oil), optionally mixed with some additive in order to stabilize these particles and prevent precipitation. The magnetorheological fluid is then encapsulated between two transparent layers of preferably a tough material, as can be polyurethane, polystyrene, PET, PEN, etc. The magnetic viewing film (5) so constituted comprises a non-dark coloured capsule in such a manner that the particles of the viewing film (5) can be easily viewed with higher contrast.

This magnetic viewing film (5) is especially necessary in cases when the magnetic strip (2) is usually dark coloured, black or dark-brown (though it can be encapsulated using layers with other colours), and the magnetic pattern coded in the magnetic strip (2) is invisible to the human eye.

In a third preferred embodiment, the magnetic viewing film (5) is attached to the label (1) in such a way that the magnetic pattern is permanently displayed on the meter, being visible to the customer, such that this magnetic viewing film (5) can discourage him from manipulating the meter (6).

In a fourth preferred embodiment, the magnetic viewing film (5) is separately disposed from the label (1), preferably being placed in a tool (10) for detecting the destruction of the magnetic pattern of the magnetic strip (2) by the application of the external magnetic field on the label (1). So, the customer ignores the presence of the magnetic pattern.

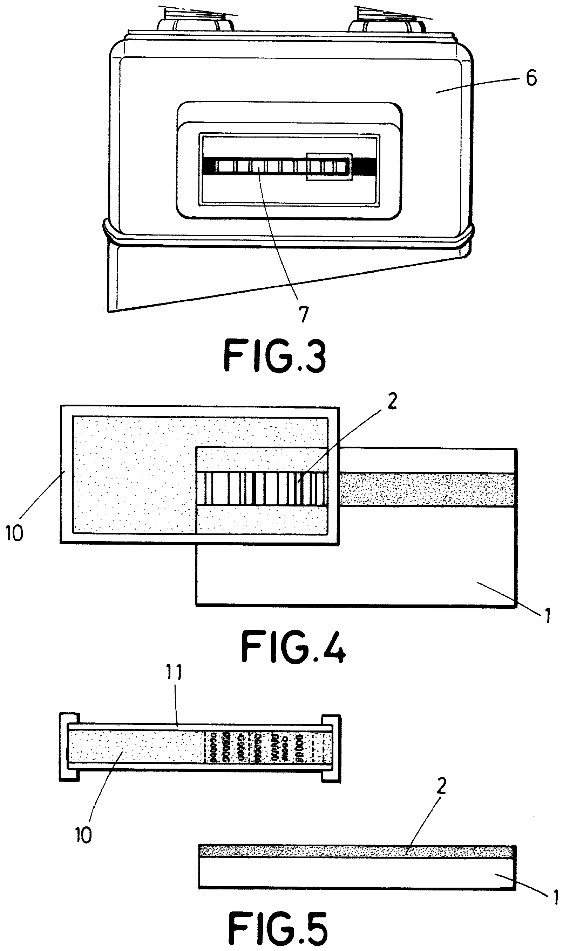

As shown in Figures 4 and 5, a visible pattern (11) of the label (1) is displayed by the tool (10) comprising the magnetic viewing film (5) due to the properly reorganization of the micro-particles inside the fluid with the magnetic field of the stripe. If the meter (6) is manipulated with the use of a magnetic field, the organized magnetic domains of the magnetic strip (2) are destroyed and no visible pattern would be displayed, so the particles will remain randomly oriented or aggregated according to the effect of the magnetic field of the external magnet over them.

The method for detecting fraud in fluid meters comprises the following stages:
- a stage of attaching at least one magnetic strip (2) previously coded with a magnetic pattern to the meter (6),
- a stage of inspecting the magnetic strip (2) to verify if the magnetic pattern has been changed.

Preferably, the stage of attaching the at least one magnetic strip (2) coded with the a magnetic pattern to the meter (6) comprises attaching the at least one magnetic strip (2) to a label (1) before attaching the label (1) and the at least one magnetic strip (2) to the meter (6), preferably to a gauge (7) of the meter (6).

The method for detecting fraud in meters further comprises:
- a stage of checking a magnetic viewing film (5), wherein the magnetic viewing film (5) is capable of reacting to the external magnetic field applied on the label (1) and being capable of displaying the magnetic pattern of the magnetic strip (2), discerning if the magnetic pattern coded in the magnetic strip (2) has been destroyed by the use of the external magnetic field applied on the label (1).

Optionally, the method also comprises a stage of coding the at least one magnetic strip (2) with the magnetic pattern previous to the stage of attaching the at least one magnetic strip (2) previously coded with the magnetic pattern to the label (1) or directly to the meter (6).

Optionally, the method also comprises a stage of checking a magnetic viewing film, wherein the magnetic viewing film is capable of reacting to the external magnetic field applied on the label and being capable of displaying the magnetic pattern of the at least one magnetic strip, thus discerning if the magnetic pattern coded in the at least one magnetic strip has been at least partially damaged or destroyed by the use of the external magnetic field applied on the label.

Preferably this stage of checking a magnetic viewing film (5) can be made by means of an external tool or can be shown in the meter (6).

## Claims

1. Device for detecting fraud in meters, the fraud that takes place by applying an external magnetic field on the meter (6) wherein the device comprises:
• at least one magnetic strip (2), and
• means (1) to couple the at least one magnetic strip to the meter (6) **characterised in that** the at least one magnetic strip (2) is coded with a magnetic pattern, wherein the magnetic pattern of the at least one magnetic strip (2) is destroyable by the application of the external magnetic field.

2. Device for detecting fraud in meters, according to claim 1, **characterised in that** the magnetic pattern is invisible to the human eye.

3. Device for detecting fraud in meters, according to any of previous claims, **characterised in that** the means to couple the at least one magnetic strip to the meter (6) comprise a label (1) coupled to the meter (6).

4. Device for detecting fraud in meters according to claim 3 **characterised in that** it also comprises fixing means (3) for permanently joining the label (1), and in consequence the at least one magnetic strip (2) to the meter (3).

5. Device for detecting fraud in meters according to claim 4 **characterised in that** the fixing means (3) are a glued film.

6. Device for detecting fraud in meters according to any of previous claims 3 to 5 **characterised in that** it also comprises a protective layer (4) disposed over the label (1) which covers entirely the device.

7. Device for detecting fraud in meters according to claim 6 **characterised in that** it also comprises a magnetic viewing film (5) being capable of reacting to the external magnetic field applied on the label (1) and being capable of displaying the magnetic pattern of the at least one magnetic strip (2).

8. Device for detecting fraud in meters according to claim 7 **characterised in that** the magnetic viewing film (5) comprises particles contained inside it suspended in a fluid carrier, which allows said particles to respond to the external magnetic field and be orientated over it, so the magnetic pattern is visually displayed.

9. Device for detecting fraud in meters according to claim 8 **characterised in that** the magnetic viewing film (5) is encapsulated between two transparent layers.

10. Device for detecting fraud in meters according to claim 9 **characterised in that** the magnetic viewing film (5) is a microencapsulated flexible viewing film comprising two thin transparent layers with magnetic micro-particles captured in between and a transparent capsule to protect it (5).

11. Device for detecting fraud in meters according to claim 9 **characterised in that** the magnetic viewing film (5) is a magnetorheological fluid (MRF) consisting in a dispersion of magnetic micro-particles on a fluid carrier.

12. Device for detecting fraud in meters according to claim 7 **characterised in that** the magnetic viewing film (5) is attached to the label (1) in such a way that the magnetic pattern is permanently displayed on the meter.

13. Device for detecting fraud in meters according to claim 7 **characterised in that** the magnetic viewing film (5) is separately disposed from the label (1).

14. Device for detecting fraud in meters according to claim 13 **characterised in that** the magnetic viewing film (5) is placed in a tool (10) for detecting the destruction of the magnetic pattern of the at least one magnetic strip (2) by the application of the external magnetic field on the label (1).

15. Device for detecting fraud in meters according to claim 14 **characterised in that** the tool (10) displays a visible pattern (11) of the label (1).

16. Device for detecting fraud in meters according to any of the previous claims **characterised in that** the at least one magnetic strip (2) presents a coercivity higher than around 2700 Oersted with a magnetic flux density higher than 0.2T.

17. Meter comprising the device according to any of the previous claims.

18. Method for detecting fraud in meters **characterised in that** it comprises the following stages:
• a stage of attaching at least one magnetic strip (2) coded with a magnetic pattern to the meter (6),
• a stage of inspecting the magnetic strip (2) to verify if the magnetic pattern has been changed, and
• a stage of checking a magnetic viewing film (5), wherein the magnetic viewing film (5) is capable of reacting to the external magnetic field applied on the at least one magnetic strip (2) and being capable of displaying the magnetic pattern of the at least one magnetic strip (2), discerning if the magnetic pattern coded in the at least one magnetic strip (2) has been at least partially damaged or destroyed by the use of the external magnetic field applied on the at least one magnetic strip (2).

19. Method for detecting fraud in meters, according to claim 18, **characterised in that** the stage of attaching the at least one magnetic strip (2) coded with the magnetic pattern to the meter (6) is a stage of attaching to the meter (6) at least one magnetic strip (2) being coded with an invisible to the human eye magnetic pattern.

20. Method for detecting fraud in meters, according to any of claims 18 or 19, **characterised in that**:
• the stage of attaching the at least one magnetic strip (2) coded with the magnetic pattern to the meter (6) comprises attaching the at least one magnetic strip (2) to a label (1) before attaching the label (1) and the at least one magnetic strip (2) to the meter (6).

21. Method for detecting fraud in meters according to any of claims 18 to 20 **characterised in that** it also comprises:
• a stage of coding at least one magnetic strip (2) with a magnetic pattern previous to the stage of attaching the at least one magnetic strip (2) coded with the magnetic pattern to the meter (6) or to the label (1).

22. Method for detecting fraud in meters according to claim 18 **characterised in that** the stage of checking the magnetic viewing film (5) is carried out by means of an external tool.

23. Method for detecting fraud in meters according to claim 18 **characterised in that** the stage of checking the magnetic viewing film (5) is shown in the meter (6).

## Patentansprüche

1. Vorrichtung zur Aufdeckung von Betrug bei Messgeräten, wobei die Täuschung durch Anlegen eines externen Magnetfelds an das Messgerät (6) erfolgt, wobei die Vorrichtung umfasst:
• zumindest einen Magnetstreifen (2) und
• ein Mittel (1) zum Koppeln des zumindest einen Magnetstreifens mit dem Messgerät (6), **dadurch gekennzeichnet, dass** der zumindest eine Magnetstreifen (2) mit einem Magnetmuster verschlüsselt ist, wobei das Magnetmuster des zumindest einen Magnetstreifens (2) durch das Anlegen des externen Magnetfelds zerstörbar ist.

2. Vorrichtung zur Aufdeckung von Betrug bei Messgeräten nach Anspruch 1, **dadurch gekennzeichnet, dass** das Magnetmuster für das menschliche Auge unsichtbar ist.

3. Vorrichtung zum Nachweis einer Täuschung bei Messgeräten nach einem der vorstehenden Ansprüche, **dadurch gekennzeichnet, dass** das Mittel zum Koppeln des zumindest einen Magnetstreifens mit dem Messgerät (6) ein mit dem Messgerät (6) gekoppeltes Etikett (1) umfasst.

4. Vorrichtung zur Aufdeckung von Betrug bei Messgeräten nach Anspruch 3, **dadurch gekennzeichnet, dass** sie auch ein Befestigungsmittel (3) zum dauerhaften Anfügen des Etiketts (1) und in weiterer Folge des zumindest einen Magnetstreifens (2) an dem Messgerät (3) umfasst

5. Vorrichtung zur Aufdeckung von Betrug bei Messgeräten nach Anspruch 4, **dadurch gekennzeichnet, dass** das Befestigungsmittel (3) ein Klebefilm ist.

6. Vorrichtung zur Aufdeckung von Betrug bei Messgeräten nach einem der vorstehenden Ansprüche 3 bis 5, **dadurch gekennzeichnet, dass** sie auch eine über dem Etikett (1) angeordnete Schutzschicht (4) umfasst, die die Vorrichtung vollständig abdeckt.

7. Vorrichtung zur Aufdeckung von Betrug bei Messgeräten nach Anspruch 6, **dadurch gekennzeichnet, dass** sie auch einen Magnetsichtfilm (5) umfasst, der in der Lage ist, auf das externe Magnetfeld zu reagieren, der an das Etikett (1) angelegt wird, und der in der Lage ist, das Magnetmuster des zumindest einen Magnetstreifens (2) anzuzeigen.

8. Vorrichtung zur Aufdeckung von Betrug bei Messgeräten nach Anspruch 7, **dadurch gekennzeichnet, dass** der Magnetsichtfilm (5) Teilchen umfasst, die darin in einer Fluidkammer suspendiert enthalten sind, was ermöglicht, dass die Teilchen auf das externe Magnetfeld reagieren und über dieses so ausgerichtet werden, dass das Magnetmuster visuell angezeigt wird.

9. Vorrichtung zur Aufdeckung von Betrug bei Messgeräten nach Anspruch 8, **dadurch gekennzeichnet, dass** der Magnetsichtfilm (5) zwischen zwei transparenten Schichten verkapselt ist.

10. Vorrichtung zur Aufdeckung von Betrug bei Messgeräten nach Anspruch 9, **dadurch gekennzeichnet, dass** der Magnetsichtfilm (5) ein mikroverkapselter, flexibler Sichtfilm ist, der zwei dünne, transparente Schichten mit dazwischen eingefassten Magnetmikroteilchen und einer transparenten Kapsel zu seinem (5) Schutz umfasst.

11. Vorrichtung zur Aufdeckung von Betrug bei Messgeräten nach Anspruch 9, **dadurch gekennzeichnet, dass** der Magnetsichtfilm (5) ein magnetorheologisches Fluid (MRF) ist, das in einer Dispersion von Magnetmikroteilchen auf einem fluiden Träger besteht.

12. Vorrichtung zur Aufdeckung von Betrug bei Messgeräten nach Anspruch 7, **dadurch gekennzeichnet, dass** der Magnetsichtfilm (5) derart an dem Etikett (1) angebracht ist, dass das Magnetmuster dauerhaft auf dem Messgerät angezeigt wird.

13. Vorrichtung zur Aufdeckung von Betrug bei Messgeräten nach Anspruch 7, **dadurch gekennzeichnet, dass** der Magnetsichtfilm (5) getrennt von dem Etikett (1) angeordnet ist.

14. Vorrichtung zur Aufdeckung von Betrug bei Messgeräten nach Anspruch 13, **dadurch gekennzeichnet, dass** der Magnetsichtfilm (5) in einem Werkzeug (10) zur Aufdeckung der Zerstörung des Magnetmusters des zumindest einen Magnetstreifens (2) durch das Anlegen des externen Magnetfelds an das Etikett (1) platziert ist.

15. Vorrichtung zur Aufdeckung von Betrug bei Messgeräten nach Anspruch 14, **dadurch gekennzeichnet, dass** das Werkzeug (10) ein sichtbares Muster (11) des Etiketts (1) anzeigt.

16. Vorrichtung zur Aufdeckung von Betrug bei Messgeräten nach einem der vorstehenden Ansprüche, **dadurch gekennzeichnet, dass** der zumindest eine Magnetstreifen (2) eine Koerzitivkraft von mehr als etwa 2700 Oersted mit einer magnetischen Flussdichte von mehr als 0,2 T aufweist.

17. Messgerät, umfassend die Vorrichtung nach einem der vorstehenden Ansprüche.

18. Verfahren zur Aufdeckung von Betrug bei Messgeräten, **dadurch gekennzeichnet, dass** es die folgenden Stufen umfasst:
• eine Stufe des Anbringens zumindest eines mit einem Magnetmuster verschlüsselten Magnetstreifens (2) an dem Messgerät (6),
• eine Stufe des Begutachtens des Magnetstreifens (2), um festzustellen, ob das Magnetmuster geändert worden ist, und
• eine Stufe des Überprüfens eines Magnetsichtfilms (5), wobei der Magnetsichtfilm (5) in der Lage ist, auf das an den zumindest einen Magnetstreifen (2) angelegte externe Magnetfeld zu reagieren, und in der Lage ist, das Magnetmuster des zumindest einen Magnetstreifens (2) anzuzeigen, wobei erkannt wird, ob das in dem zumindest einen Magnetstreifen (2) verschlüsselte Magnetmuster mithilfe des an den zumindest einen Magnetstreifen (2) angelegten externen Magnetfelds zumindest teilweise beschädigt oder zerstört worden ist.

19. Verfahren zur Aufdeckung von Betrug bei Messgeräten nach Anspruch 18, **dadurch gekennzeichnet, dass** die Stufe des Anbringens des zumindest einen mit dem Magnetmuster verschlüsselten Magnetstreifens (2) an dem Messgerät (6) eine Stufe des Anbringens zumindest eines Magnetstreifens (2), der mit einem für das menschliche Auge unsichtbaren Magnetmuster verschlüsselt ist, an dem Messgerät (6) ist.

20. Verfahren zur Aufdeckung von Betrug bei Messgeräten nach einem der Ansprüche 18 und 19, **dadurch gekennzeichnet, dass**:
• die Stufe des Anbringens des zumindest einen mit dem Magnetmuster verschlüsselten Magnetstreifens (2) an dem Messgerät (6) das Anbringen des zumindest einen Magnetstreifens (2) an einem Etikett (1) vor dem Anbringen des Etiketts (1) und des zumindest einen Magnetstreifens (2) an dem Messgerät (6) umfasst.

21. Verfahren zur Aufdeckung von Betrug bei Messgeräten nach einem der Ansprüche 18 bis 20, **dadurch gekennzeichnet, dass** es auch umfasst:
• eine Stufe des Verschlüsselns zumindest eines Magnetstreifens (2) mit einem Magnetmuster vor der Stufe des Anbringens des zumindest einen mit dem Magnetmuster verschlüsselten Magnetstreifens (2) an dem Messgerät (6) oder an dem Etikett (1).

22. Verfahren zur Aufdeckung von Betrug bei Messgeräten nach Anspruch 18, **dadurch gekennzeichnet, dass** die Stufe des Überprüfens des Magnetsichtfilms (5) mittels eines externen Werkzeugs ausgeführt wird.

23. Verfahren zur Aufdeckung von Betrug bei Messgeräten nach Anspruch 18, **dadurch gekennzeichnet, dass** die Stufe des Überprüfens des Magnetsichtfilms (5) in dem Messgerät (6) gezeigt wird.

## Revendications

1. Dispositif de détection de fraudes dans des compteurs, la fraude survenant suite à l'application d'un champ magnétique externe sur le compteur (6), le dispositif comprenant :
• au moins une bande magnétique (2), et
• un moyen (1) d'assemblage de ladite au moins une bande magnétique au compteur (6), caractérisé parce que ladite au moins une bande magnétique (2) est codée avec un motif magnétique, dans lequel le motif magnétique de ladite au moins une bande magnétique (2) peut être détruit par l'application du champ magnétique externe.

2. Dispositif de détection de fraudes dans des compteurs selon la revendication 1, caractérisé parce que le motif magnétique est invisible à l'œil humain.

3. Dispositif de détection de fraudes dans des compteurs selon l'une quelconque des revendications précédentes, caractérisé parce que le moyen d'assemblage de ladite au moins une bande magnétique au compteur (6) comprend une étiquette (1) reliée au compteur (6).

4. Dispositif de détection de fraudes dans des compteurs selon la revendication 3, **caractérisé en ce qu'**il comprend également un moyen de fixation (3) permettant d'assembler de manière permanente l'étiquette (1), et donc ladite au moins une bande magnétique (2), au compteur (3).

5. Dispositif de détection de fraudes dans des compteurs selon la revendication 4, caractérisé parce que le moyen de fixation (3) est une pellicule adhésive.

6. Dispositif de détection de fraudes dans des compteurs selon l'une quelconque des revendications 3 à 5, **caractérisé en ce qu'**il comprend également une couche protectrice (4), disposée sur l'étiquette (1), qui recouvre intégralement le dispositif.

7. Dispositif de détection de fraudes dans des compteurs selon la revendication 6, **caractérisé en ce qu'**il comprend également une pellicule de visualisation magnétique (5) capable de réagir au champ magnétique externe appliqué sur l'étiquette (1) et capable d'afficher le motif magnétique de ladite au moins une bande magnétique (2).

8. Dispositif de détection de fraudes dans des compteurs selon la revendication 7, caractérisé parce que la pellicule de visualisation magnétique (5) comprend en son intérieur des particules en suspension dans un liquide porteur, qui permet auxdites particules de répondre au champ magnétique externe et d'être orientées sur lui, de telle sorte que le motif magnétique est affiché.

9. Dispositif de détection de fraudes dans des compteurs selon la revendication 8, caractérisé parce que la pellicule de visualisation magnétique (5) est encapsulée entre deux couches transparentes.

10. Dispositif de détection de fraudes dans des compteurs selon la revendication 9, caractérisé parce que la pellicule de visualisation magnétique (5) est une pellicule de visualisation flexible microencapsulée comprenant deux couches transparentes fines avec des microparticules magnétiques capturées entre les deux couches et une capsule transparente permettant de la protéger (5).

11. Dispositif de détection de fraudes dans des compteurs selon la revendication 9, caractérisé parce que la pellicule de visualisation magnétique (5) est un fluide magnétorhéologique (MRF pour *magnetorheological fluid*) consistant en une dispersion de microparticules magnétiques sur un liquide porteur.

12. Dispositif de détection de fraudes dans des compteurs selon la revendication 7, caractérisé parce que la pellicule de visualisation magnétique (5) est jointe à l'étiquette (1) de telle façon que le motif magnétique est affiché en permanence sur le compteur.

13. Dispositif de détection de fraudes dans des compteurs selon la revendication 7, caractérisé parce que la pellicule de visualisation magnétique (5) est disposée à distance de l'étiquette (1).

14. Dispositif de détection de fraudes dans des compteurs selon la revendication 13, caractérisé parce que la pellicule de visualisation magnétique (5) est placée dans un outil (10) de détection de la destruction du motif magnétique de ladite au moins une bande magnétique (2) via l'application du champ magnétique externe sur l'étiquette (1).

15. Dispositif de détection de fraudes dans des compteurs selon la revendication 14, caractérisé parce que l'outil (10) affiche un motif visible (11) de l'étiquette (1).

16. Dispositif de détection de fraudes dans des compteurs selon l'une quelconque des revendications précédentes, caractérisé parce que ladite au moins une bande magnétique (2) présente une coercivité supérieure à environ 2700 œrsted avec une densité de flux magnétique supérieure à 0,2 T.

17. Compteur comprenant le dispositif selon l'une quelconque des revendications précédentes.

18. Méthode de détection de fraudes dans des compteurs, **caractérisée en ce qu'**elle comprend les étapes suivantes :
• une étape d'assemblage d'au moins une bande magnétique (2) codée avec un motif magnétique au compteur (6),
• une étape d'inspection de la bande magnétique (2) afin de vérifier si le motif magnétique a été modifié, et
• une étape de contrôle d'une pellicule de visualisation magnétique (5), dans laquelle la pellicule de visualisation magnétique (5) est capable de réagir au champ magnétique externe appliqué sur ladite au moins une bande magnétique (2) et est capable d'afficher le motif magnétique d'au moins une bande magnétique (2), déterminant si le motif magnétique codé dans ladite au moins une bande magnétique (2) a été au moins partiellement endommagé ou détruit par l'utilisation du champ magnétique externe appliqué sur ladite au moins une bande magnétique (2).

19. Méthode de détection de fraudes dans des compteurs selon la revendication 18, **caractérisée** parce que l'étape d'assemblage de ladite au moins une bande magnétique (2) codée avec le motif magnétique au compteur (6) consiste à joindre au compteur (6) au moins une bande magnétique (2) codée avec un motif magnétique invisible à l'œil humain.

20. Méthode de détection de fraudes dans des compteurs selon l'une quelconque des revendications 18 ou 19, **caractérisée** parce que :
• l'étape d'assemblage de ladite au moins une bande magnétique (2) codée avec le motif magnétique au compteur (6) comprend la fixation d'une étiquette (1) à ladite au moins une bande magnétique (2) avant de fixer l'étiquette (1) et ladite au moins une bande magnétique (2) au compteur (6).

21. Méthode de détection de fraudes dans des compteurs selon l'une quelconque des revendications 18 à 20, **caractérisée en ce qu'**elle comprend également :
• une étape de codage d'au moins une bande magnétique (2) avec un motif magnétique avant l'étape d'assemblage de ladite au moins une bande magnétique (2) codée avec le motif magnétique au compteur (6) ou à l'étiquette (1).

22. Méthode de détection de fraudes dans des compteurs selon la revendication 18, **caractérisée** parce que l'étape de contrôle de la pellicule de visualisation magnétique (5) est effectuée au moyen d'un outil externe.

23. Méthode de détection de fraudes dans des compteurs selon la revendication 18, **caractérisée** parce que l'étape de contrôle de la pellicule de visualisation magnétique (5) est montrée dans le compteur (6).
